# EUROPEAN PATENT SPECIFICATION

(11) **EP 2 299 122 B1**
(45) Date of publication and mention of the grant of the patent: **14.03.2018**
(21) Application number: 10009327.7
(22) Date of filing: 08.09.2010
(51) Int. Cl.: F04D 25/06, F04D 27/02, F04D 29/42, F04D 29/70, H01L 23/467, H05K 7/20

(54) **Heat dissipating fan**
Wärmeableitendes Gebläse
Ventilateur à dissipation thermique

(30) Priority: 08.09.2009 TW 98130216
(43) Date of publication of application: 23.03.2011
(73) Proprietor: Sunonwealth Electric Machine Industry Co., Ltd., Kaohsiung, Taiwan R.O.C. (TW)
(72) Inventor: Horng, Alex, Kaohsiung Taiwan R.O.C (TW); Lee, Chao-Hsun, Kaohsiung Taiwan R.O.C (TW); Wang, Chi-Min, Kaohsiung Taiwan R.O.C (TW)
(74) Representative: Louis Pöhlau Lohrentz

(56) References cited:
- JP-A- H02 163 498
- JP-A- 2008 140 943
- US-A- 5 381 886
- US-A1- 2006 045 742
- US-A1- 2009 215 380

## Description

### BACKGROUND OF THE INVENTION

### 1. Field of the Invention

The present invention relates to a heat dissipating fan and, more particularly, to a heat dissipating fan with automatic dust removing function.

### 2. Description of the Related Art

Conventional heat dissipating fans generally include a housing having an air inlet and an air outlet. An impeller is rotatably mounted in the housing and driven by a driving unit also mounted in the housing to draw in ambient air via the air inlet. The air currents drawn into the housing are concentrated before exiting the air outlet to a heat source in an electronic product. The temperature during operation of the heat source is thus lowered. However, dust carried by the air currents is liable to accumulate inside the housing at the air inlet, the air outlet, the blades of the impeller, etc., adversely affecting the air input and/or air output and thus, adversely affecting the heat dissipating effect.

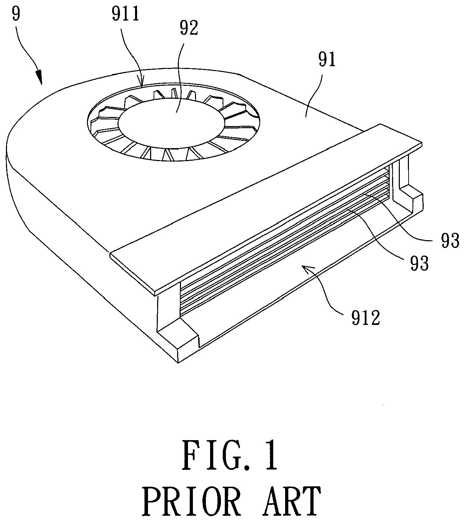

FIG. 1 shows a heat dissipating fan 9 which includes a housing 91 having an air inlet 911 and an air outlet 912. An impeller 92 is mounted in the housing 91. A plurality of fins 93 is mounted in the air outlet 912. Air currents can be driven by the impeller 92 into the housing 91 via the air inlet 911. The air currents pass through the fins 93 and the air outlet 912 to a heat source of an electronic product. An example of such a blower fan 9 is disclosed in Taiwan Patent No. I229254. However, dust is liable to accumulate inside the housing 91 after a period of time. Since the spacing between the fins 93 is small, the dust is liable to accumulate between the fins 93, significantly reducing the air output and requiring regular manual cleaning.

United States patent application US 2006/0045742 A1 discloses an air fan comprising a water filter which can filter dust and impurities in the air during the operation of the air fan.

### SUMMARY OF THE INVENTION

An objective of the present invention is to provide a heat dissipating fan that can remove dust automatically.

Another objective of the present invention is to provide a heat dissipating fan with reliable input and output of air by automatically removing dust.

The present invention fulfills the above objectives by providing, in a preferred aspect, a heat dissipating fan which includes a housing having a base and a sidewall coupled to the base. The sidewall defines a compartment. The housing further includes an air inlet, an air outlet and a dust channel. The air inlet, the air outlet and the dust channel are in communication with the compartment. A stator is coupled to the base of the housing. An impeller is rotatably coupled to the stator. A control element includes a driving circuit electrically connected to the stator for driving the impeller to rotate. The housing further includes a dust channel communicating the compartment with an outside, the control element further includes a rotating direction control circuit electrically connected to the driving circuit. When the rotating direction control circuit controls the impeller to rotate in a first direction, ambient air currents are drawn in via the air inlet and pass through the air outlet to a heat source for dissipating heat. When the rotating direction control circuit controls the impeller to rotate in a second direction reverse to the first direction, ambient air currents are drawn in via the air inlet and then exit the housing via the dust channel to dispel dust accumulated inside the housing.

The present invention will become clearer in light of the following detailed description of its illustrative embodiments described in connection with the drawings.

### BRIEF DESCRIPTION OF THE DRAWINGS

The illustrative embodiments may best be described by referring to the accompanying drawings where:
FIG. 1 shows a perspective view of a conventional heat dissipating fan.
FIG 2 shows an exploded, perspective view of a heat dissipating fan of a first embodiment according to the preferred teachings of the present invention.
FIG. 3 shows a top view of the heat dissipating fan of FIG. 2 after removal of a cover of the heat dissipating fan and with the heat dissipating fan rotating in a direction for heat dissipating purposes.
FIG. 4 shows a top view of the heat dissipating fan of FIG. 2 after removal of the cover of the heat dissipating fan and with the heat dissipating fan rotating in a reverse direction for dust removing purposes.
FIG. 5 shows a top view of another case of the heat dissipating fan of the first embodiment after removal of the cover of the heat dissipating fan, with a dust guiding pipe attached to the heat dissipating fan, and with the heat dissipating fan rotating in a direction for dust removing purposes.
FIG. 6 shows an exploded, perspective view of a heat dissipating fan of a second embodiment according to the preferred teachings of the present invention.
FIG. 7 shows a top view of the heat dissipating fan of FIG. 6 with the heat dissipating fan rotating in a direction for heat dissipating purposes.
FIG. 8 shows a cross sectional view of the heat dissipating fan of FIG. 6.

All figures are drawn for ease of explanation of the basic teachings of the present invention only; the extensions of the figures with respect to number, position, relationship, and dimensions of the parts to form the preferred embodiments will be explained or will be within the skill of the art after the following teachings of the present invention have been read and understood. Further, the exact dimensions and dimensional proportions that conform to specific force, weight, strength, and similar requirements will likewise be within the skill of the art after the following teachings of the present invention have been read and understood.

Where used in the various figures of the drawings, the same numerals designate the same or similar parts. Furthermore, when the terms "first", "second", "inner", "outer", "end", "section", "clockwise", "counterclockwise", and similar terms are used herein, it should be understood that these terms refer only to the structure shown in the drawings as it would appear to a person viewing the drawings and are utilized only to facilitate describing the invention.

### DETAILED DESCRIPTION OF THE INVENTION

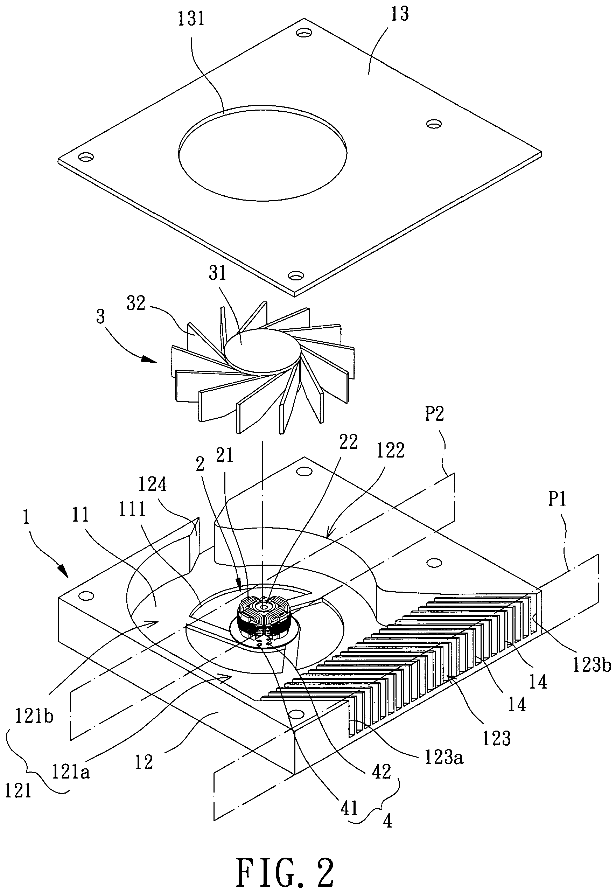

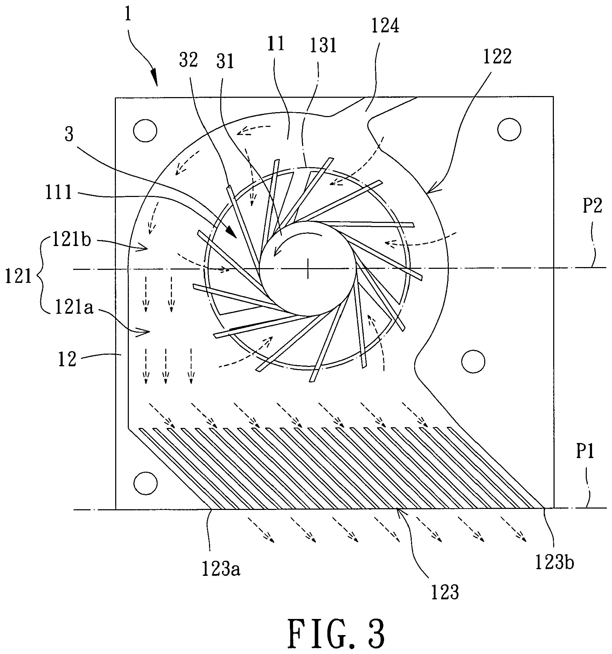

With reference to FIGS. 2 and 3, a heat dissipating fan of a first embodiment according to the preferred teachings of the present invention generally includes a housing 1, a stator 2, an impeller 3, and a control element 4. The housing 1 can be mounted in a desired location of an electronic product, such as a face of a main board inside a computer. The stator 2 is mounted in the housing 1. The impeller 3 is mounted in the housing 1 and rotatably coupled to the stator 2. The control element 4 controls the impeller 3 to rotate either in a direction for generating enough air for heat dissipating purposes or in a reverse direction for dust removing purposes by cooperating with the structure of the housing 1.

Specifically, the housing 1 includes a base 11 and a sidewall 12 coupled to a side of the base 11 and defining a compartment 121. The sidewall 12 includes an air inlet 122 and an air outlet 123 both in communication with the compartment 121. The sidewall 12 further includes a dust channel 124 in communication with the compartment 121. It can be appreciated that the sidewall 12 can include more than one dust channel 124.

The stator 2 is mounted to the base 11 of the housing 1 and includes a coil unit 21 and a shaft seat 22. The coil unit 21 is mounted around or integrally formed with an outer periphery of the shaft seat 22. Alternatively, instead of being mounted to the base 11, the shaft seat 22 of the stator 2 may be integrally formed on the base 11.

The impeller 3 includes a hub 31 and a plurality of blades 32. The hub 31 is rotatably coupled to the shaft seat 22 of the stator 2. The blades 32 are coupled to an outer periphery of the hub 31.

The control element 4 includes a driving circuit 41 and a rotating direction control circuit 42. The driving circuit 41 is electrically connected to the coil unit 21 of the stator 2. The rotating direction control circuit 42 is electrically connected to the driving circuit 41. The driving circuit 41 and the rotating direction control circuit 42 can be packaged in the same integrated circuit. Furthermore, the control element 4 can be integrated into the housing 1. However, the control element 4 can be disposed outside the housing 1 without adversely affecting control of the impeller 3.

During use of the heat dissipating fan of the first embodiment according to the preferred teachings of the present invention, the heat dissipating fan is engaged with an electronic product with the air outlet 123 of the housing 1 facing a heat source of the electronic product that tends to generate heat during operation. The rotating direction control circuit 42 can send a rotating direction control signal to the driving circuit 41 to actuate the coil unit 21 of the stator 2 to create a magnetic field for driving the impeller 3 to rotate in a direction (such as the counterclockwise direction). Ambient air currents are drawn in via the air inlet 122. The air currents are concentrated by the impeller 3 before passing through the air outlet 123 to the heat source of the electronic product for heat dissipating purposes (FIG. 3).

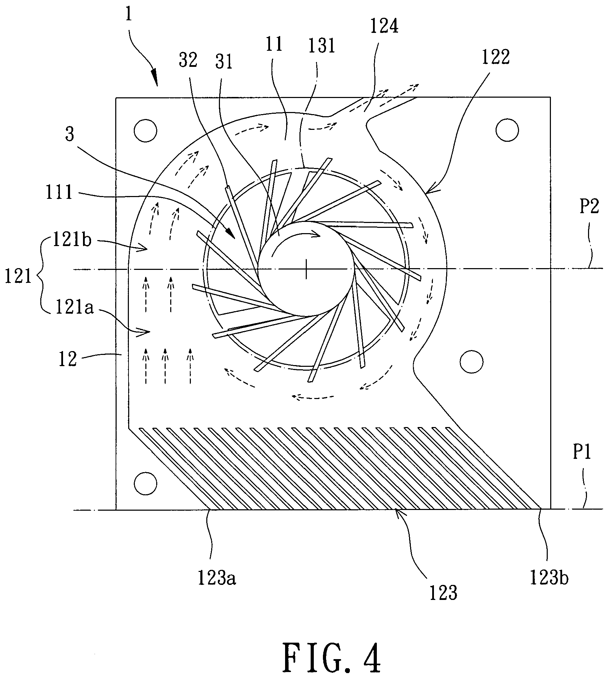

Since dust is liable to accumulate inside the housing 1 (such as at the air inlet 122, the air outlet 123, the blades 32 of the impeller 3, etc.) after a period of time, the rotating direction control circuit 42 can send another rotating direction control signal to the driving circuit 41 to actuate the coil unit 21 of the stator 2 to create a magnetic field for driving the impeller 3 to rotate in a reverse direction (such as the clockwise direction). The air inlet 122 draws in ambient air currents which then exit the housing 1 via the dust channel 124 (FIG. 4). Thus, the dust accumulated inside the housing 1 can be expelled from the housing 1 together with the air currents, eliminating accumulation of the dust. Thus, the overall air input and output are not adversely affected, effectively enhancing the heat dissipating effect.

More specifically, the rotating direction control circuit 42 can control the timing of rotation of the impeller 3 in the counterclockwise or clockwise direction through the driving circuit 41. As an example, the heat dissipating fan according to the teachings of the present invention can be set so that the impeller 3 rotates in the counterclockwise direction for a period of time (such as an hour or two) immediately after the heat dissipating fan is turned on. Then, the impeller 3 is controlled to rotate in the clockwise direction for another period of time (such as 10 or 20 minutes) for automatic removal of dust. After the automatic dust removing operation, the impeller 3 is controlled to rotate in the counterclockwise direction for heat dissipating purposes. Namely, the rotational direction of the impeller 3 can continuously alternate between the counterclockwise and clockwise directions to complete functions of heat dissipating and dust removing. In another example, the heat dissipating fan according to the teachings of the present invention can be set so that the impeller 3 rotates in the clockwise direction for a period of time for automatic dust removing operation immediately after the heat dissipating fan is turned on. Then, the impeller 3 is controlled to rotate in the counterclockwise direction for heat dissipating purposes.

By controlling the impeller 3 to rotate in a reverse direction with the rotating direction control circuit 42 via the driving circuit 41, the heat dissipating fan of the first embodiment according to the preferred teachings of the present invention can automatically remove dust without adversely affecting the heat dissipating function. Thus, accumulation of dust inside the housing 1 is eliminated to avoid adverse effect to the overall heat dissipating effect. The heat dissipating effect is thus enhanced, and the service life of the electronic product is prolonged.

The heat dissipating fan according to the teachings of the present invention can incorporate additional features to perfect the functions. Particularly, with reference to FIGS. 2 and 3, the air outlet 123 of the housing 1 includes opposite first and second end edges 123a and 123b. The housing 1 defines a first plane P1 including the first and second end edges 123a and 123b. The impeller 3 defines a second plane P2 including a center of the hub 31. The second plane P2 is parallel to and spaced from the first plane P1. The compartment 121 is divided into an air outlet section 121a and a pressure accumulating section 121b by defining the first and second planes P1 and P2. The air outlet section 121a is located between the first and second planes P1 and P2. The pressure accumulating section 121b and the air outlet section 121a are located on opposite sides of the second plane P2. The air outlet 123 is located in the air outlet section 121a. The dust channel 124 is located in the pressure accumulating section 121b. Thus, the dust channel 124 is located away from the air outlet 123. When the control element 4 controls the impeller 3 to rotate in the clockwise direction, the impeller 3 can drive the air currents from the air outlet section 121a to the pressure accumulating section 121b more thoroughly, so that the dust accumulated inside the housing 1 can be smoothly removed together with the air currents exiting the dust channel 124. The overall dust removing effect is thus enhanced.

With reference to FIG. 4, the dust channel 124 extends in a direction at an angle with the second plane P2. However, the dust channel 124 can extend in a direction perpendicular or parallel to the second plane P2. The extending direction of the dust channel 124 is preferably related to the moving direction of the air currents driven by the impeller 3 rotating in the clockwise direction. In the example shown in FIG. 4, the dust channel 124 extends in a direction at an angle with the second plane P2 to reduce resistance to the air currents that are driven by the impeller 3 to flow along an inner face of the sidewall 12 into the dust channel 124, assuring smooth dust removal operation.

With reference to FIGS. 2 and 3, a cover 13 can be mounted to the sidewall 12 of the housing 1. The cover 13 includes an opening 131 aligned with the air inlet 122. The cover 13 covers the compartment 121 over the air inlet 122, so that the air currents generated by the impeller 3 can enter the housing 1 via the opening 131 and the air inlet 122, providing a pressure increasing effect to smoothly guide the air currents to exit the air outlet 123.

With reference to FIGS. 2 and 3, the base 11 of the housing 1 can further include a plurality of auxiliary air inlets 111 aligned with the air inlet 122. The air currents generated by the impeller 3 can also enter the housing 1 via the auxiliary air inlets 111, increasing the air input.

With reference to FIGS. 2 and 3, a plurality of fins 14 can be formed in the air outlet 123. The fins 14 can be directly formed in the air outlet 123 or integrated as a heat sink mounted to the air outlet 123. Thus, when the housing 1 is coupled to the electronic product, the fins 14 can absorb the high heat generated by the heat source of the electronic product, providing further enhanced heat dissipating effect while the impeller 3 drives air currents through the air outlet 123.

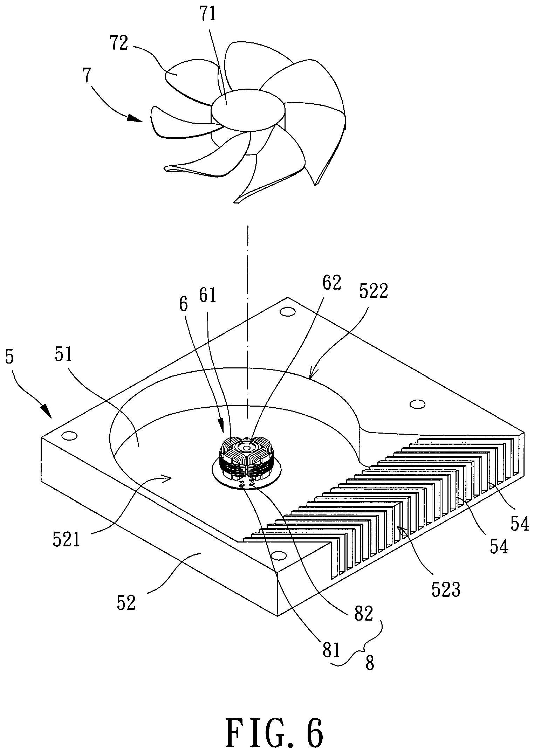

With reference to FIG. 5, a dust guiding pipe 15 can be attached to the dust channel 124 to guide the dust removed from the housing 1 away from the housing 1, assuring the dust removing effect.

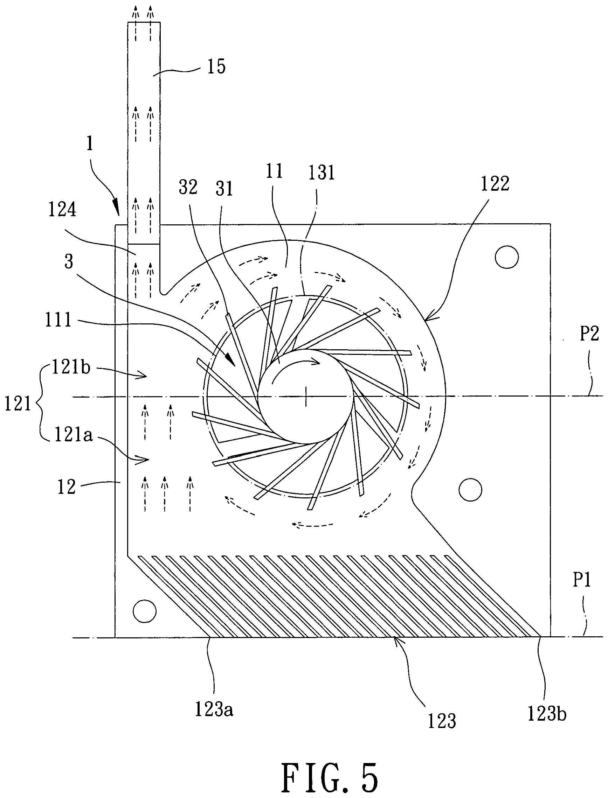

FIGS. 6-8 show a heat dissipating fan of a second embodiment according to the preferred teachings of the present invention. In this embodiment, the heat dissipating fan includes a housing 5, a stator 6, an impeller 7, and a control element 8. Although the housing 5 is preferably of the blower type, the housing 5 can be of the axial-flow type. The stator 6 is mounted in the housing 5. The impeller 7 is rotatably coupled to the stator 6. The control element 8 controls the impeller 7 to rotate in the clockwise or counterclockwise direction.

Specifically, the housing 5 includes a base 51 and a lateral wall 52. The base 51 and the lateral wall 52 together define a compartment 521. The lateral wall 52 includes an air inlet 522 and an air outlet 523 both in communication with the compartment 521. The air inlet 522 can act as a dust channel.

The stator 6 is mounted to the base 51 of the housing 5 and includes a coil unit 61 and a shaft seat 62. The coil unit 61 is mounted around or integrally formed with an outer periphery of the shaft seat 62. Alternatively, instead of being mounted to the base 51, the shaft seat 62 of the stator 6 may be integrally formed on the base 51.

The impeller 7 is mounted in the compartment 521 of the housing 5 and preferably of the axial-flow type. The impeller 7 includes a hub 71 rotatably coupled to the shaft seat 62 of the stator 6 and a plurality of blades 72 coupled to an outer periphery of the hub 71.

The control element 8 includes a driving circuit 81 and a rotating direction control circuit 82. The driving circuit 81 is electrically connected to the coil unit 61 of the stator 6. The rotating direction control circuit 82 is electrically connected to the driving circuit 81. The driving circuit 81 and the rotating direction control circuit 82 can be packaged in the same integrated circuit.

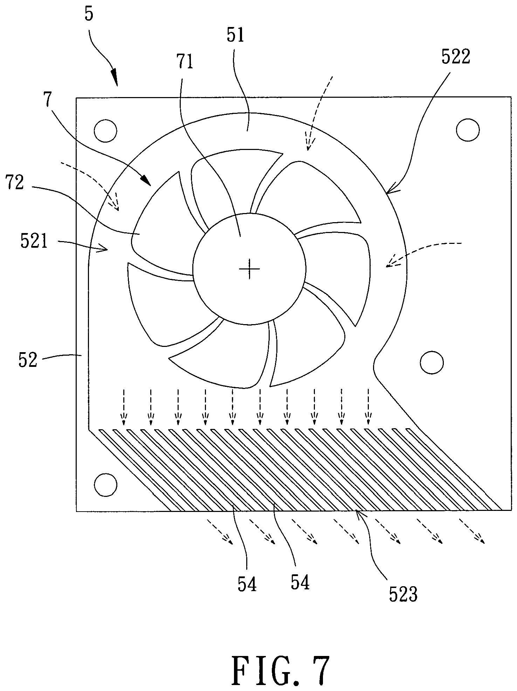

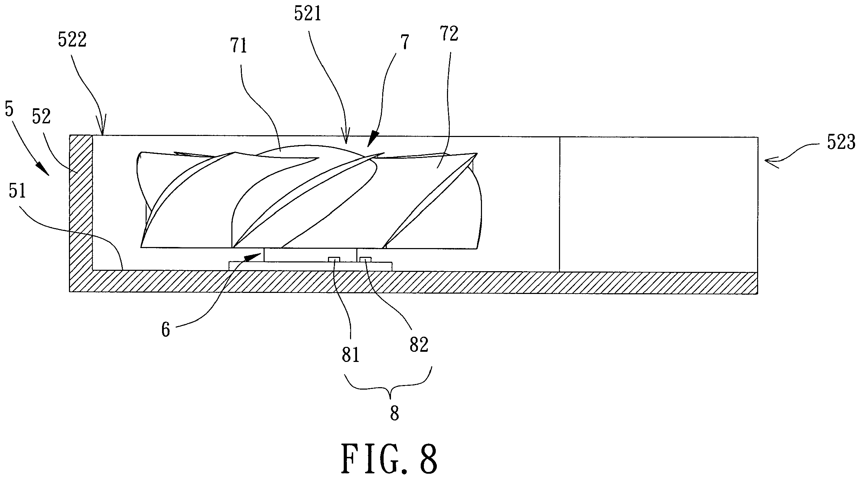

During use of the heat dissipating fan of the second embodiment according to the preferred teachings of the present invention, the rotating direction control circuit 82 can send a rotating direction control signal to the driving circuit 81 to drive the impeller 7 to rotate in a direction (such as the counterclockwise direction). The air inlet 522 draws in ambient air currents which then exit the air outlet 523 to the heat source of the electronic product for heat dissipating purpose (FIGS. 6 and 7). Furthermore, the rotating direction control circuit 82 can send another rotating direction control signal to the driving circuit 81 to drive the impeller 7 to rotate in a reverse direction (such as the clockwise direction). Due to the characteristics of the blades 72 of the axial-flow type impeller 7, the flowing direction of the air currents in the housing 5 driven by the impeller 7 rotating in the clockwise direction is opposite to that of the air currents driven by the impeller 7 rotating in the counterclockwise direction. Thus, the dust is less likely to accumulate in the housing 5. Rather, the dust is removed from the housing 5 via the air inlet 522 acting as a dust channel. Thus, the dust accumulated in the housing 5 can be expelled (FIGS. 6 and 8).

By controlling the impeller 7 to rotate in a reverse direction with the rotating direction control circuit 82 via the driving circuit 81, the heat dissipating fan of the second embodiment according to the preferred teachings of the present invention can automatically remove dust to avoid adverse effect to the overall heat dissipating effect resulting from accumulation of the dust in the housing 5 while still providing the original heat dissipating function. Furthermore, the air inlet 522 of the housing 5 can be utilized as the dust channel without the need to form a dust channel 124 in the sidewall 12 of the housing 1. The structure of the heat dissipating fan is thus simplified.

The additional features of the first embodiment can be utilized in the second embodiment according to the teachings of the present invention, details of which are not described to avoid redundancy.

In conclusion, the heat dissipating fans according to the teachings of the present invention can control the impeller 3, 7 with the rotating direction control circuit 42, 82 of the control element 4, 8 via the driving circuit 41, 81 to rotate in a reverse direction that cooperates with the dust channel 124 (or the air inlet 522 of the second embodiment), allowing effective automatic dust removal of the dust accumulated in the housing 1, 5, and thus providing convenient dust removing operation. Since the dust can be removed automatically, the dust is less likely to accumulate to an unexpected amount in the housing 1, 5, effectively maintaining the air input and output and enhancing the heat dissipating effect.

Thus since the invention disclosed herein may be embodied in other specific forms without departing from the spirit or general characteristics thereof, some of which forms have been indicated, the embodiments described herein are to be considered in all respects illustrative and not restrictive. The scope of the invention is to be indicated by the appended claims, rather than by the foregoing description, and all changes which come within the meaning and range of equivalency of the claims are intended to be embraced therein.

## Claims

1. A heat dissipating fan comprising:
a housing (1) including a base (11) and a sidewall (12) coupled to the base (11), with the sidewal (12) defining a compartment (121), with the housing (1) further including an air inlet (122) and an air outlet (123), with the air inlet (122) and the air outlet (123) being in communication with the compartment (121);
a stator (2) coupled to the base (11) of the housing (1);
an impeller (3) rotatably coupled to the stator (2); and
a control element (4) including a driving circuit (41) electrically connected to the stator (2) for driving the impeller (3) to rotate,
**characterized in that**:
the housing (1) further includes a dust channel (124) communicating the compartment (121) with an outside, the control element (4) further includes a rotating direction control circuit (42) electrically connected to the driving circuit (41),
wherein when the rotating direction control circuit (42) controls the impeller (3) to rotate in a first direction, ambient air currents are drawn in via the air inlet (122) and pass through the air outlet (123) to a heat source for dissipating heat, and
wherein when the rotating direction control circuit (42) controls the impeller (3) to rotate in a second direction reverse to the first direction, ambient air currents are drawn in via the air inlet (122) and then exit the housing (1) via the dust channel (124) to dispel dust accumulated inside the housing (1).

2. The heat dissipating fan as claimed in claim 1, **characterized in that** the air outlet (123) includes opposite first and second end edges (123a, 123b), with the housing (1) defining a first plane (P1) including the first and second end edges (123a, 123b), with the impeller (3) including a hub (31) and a plurality of blades (32) coupled to an outer periphery of the hub (31), with the impeller (3) defining a second plane (P2) including a center of the hub (31), with the second plane (P2) parallel to and spaced from the first plane (P1), with the compartment (121) of the housing (1) including an air outlet section (121a) and a pressure accumulating section (121b) on opposite sides of the second plane (P2), with the air outlet section (121a) located between the first and second planes (P1, P2), and with the dust channel (124) located in the pressure accumulating section (121b).

3. The heat dissipating fan as claimed in claim 2, **characterized in that** the dust channel (124) extends in a plane at an angle, perpendicular, or parallel to the second plane (P2).

4. The heat dissipating fan as claimed in claim 1, **characterized in that** the heat dissipating fan further comprises: a dust guiding pipe (15) attached to the dust channel (124).

5. The heat dissipating fan as claimed in claim 1, **characterized in that** the heat dissipating fan further comprises: a plurality of fins (14) mounted in the air outlet (123) of the housing (1).

6. The heat dissipating fan as claimed in claim 1, **characterized in that** the heat dissipating fan further comprises: a cover (13) coupled to the sidewall (12) of the housing (1), with the cover (13) including an opening (131) aligned with the air inlet (122).

7. The heat dissipating fan as claimed in claim 1, **characterized in that** the base (11) of the housing (1) includes a plurality of auxiliary air inlets (122).

## Patentansprüche

1. Wärmeableitungsgebläse, das Folgendes umfasst:
ein Gehäuse (1), das eine Basis (11) und eine Seitenwand (12), die mit der Basis (11) verbunden ist, umfasst, wobei die Seitenwand (12) ein Fach (121) definiert, wobei das Gehäuse (1) ferner einen Lufteinlass (122) und einen Luftauslass (123) aufweist, wobei der Lufteinlass (122) und der Luftauslass (123) mit dem Fach (121) in Kommunikation sind;
einen Stator (2), der mit der Basis (11) des Gehäuses (1) verbunden ist;
ein Gebläserad (3), das mit dem Stator (2) drehbar verbunden ist; und
ein Steuerelement (4), das eine Antriebsschaltung (41) aufweist, die mit dem Stator (2) zum rotatorischen Antreiben des Gebläserades (3) elektrisch verbunden ist,
**dadurch gekennzeichnet, dass**:
das Gehäuse (1) ferner einen Staubkanal (124) aufweist, der eine Verbindung zwischen dem Fach (121) und einer äußeren Umgebung herstellt, wobei das Steuerelement (4) ferner eine Drehrichtung-Steuerschaltung (42) umfasst, die mit der Antriebsschaltung (41) elektrisch verbunden ist,
wobei dann, wenn die Drehrichtung-Steuerschaltung (42) das Gebläserad (3) so steuert, dass es sich in einer ersten Richtung dreht, Umgebungsluftströme über den Lufteinlass (122) hineingesaugt werden und durch den Luftauslass (123) zu einer Wärmequelle zum Ableiten von Wärme gelangen,
und
wobei dann, wenn die Drehrichtung-Steuerschaltung (42) das Gebläserad (3) so steuert, dass es sich in einer zweiten Richtung entgegengesetzt zu der ersten Richtung dreht, Umgebungsluftströme über den Lufteinlass (122) hineingesaugt werden und dann das Gehäuse (1) über den Staubkanal (124) verlassen, um Staub, der sich in dem Gehäuse (1) angesammelt hat, zu beseitigen.

2. Wärmeableitungsgebläse nach Anspruch 1, **dadurch gekennzeichnet, dass** der Luftauslass (123) einander gegenüberliegende erste und zweite Kanten (123a, 123b) aufweist, wobei das Gehäuse (1) eine erste Ebene (P1) definiert, die die erste und die zweite Kante (123a, 123b) umfasst, wobei das Gebläserad (3) eine Nabe (31) und mehrere Flügel (32), die mit einem Außenumfang der Nabe (31) verbunden sind, aufweist, wobei das Gebläserad (3) eine zweite Ebene (P2) definiert, die das Zentrum der Nabe (31) umfasst, wobei die zweite Ebene (P2) zu der ersten Ebene (P1) parallel ist und von dieser beabstandet ist, wobei das Fach (121) des Gehäuses (1) einen Luftauslassabschnitt (121a) und einen Druckaufbauabschnitt (121b) an gegenüberliegenden Seiten der zweiten Ebene (P2) aufweist, wobei sich der Luftauslassabschnitt (121a) zwischen der ersten und der zweiten Ebene (P1, P2) befindet und wobei sich der Staubkanal (124) in dem Druckaufbauabschnitt (121b) befindet.

3. Wärmeableitungsgebläse nach Anspruch 2, **dadurch gekennzeichnet, dass** sich der Staubkanal (124) in einer Ebene mit einem Winkel, senkrecht oder parallel zu der zweiten Ebene (P2) erstreckt.

4. Wärmeableitungsgebläse nach Anspruch 1, **dadurch gekennzeichnet, dass** das Wärmeableitungsgebläse ferner Folgendes umfasst: ein Staubführungsrohr (15), das an dem Staubkanal (124) befestigt ist.

5. Wärmeableitungsgebläse nach Anspruch 1, **dadurch gekennzeichnet, dass** das Wärmeableitungsgebläse ferner Folgendes umfasst: mehrere Rippen (14), die in dem Luftauslass (123) des Gehäuses (1) angebracht sind.

6. Wärmeableitungsgebläse nach Anspruch 1, **dadurch gekennzeichnet, dass** das Wärmeableitungsgebläse ferner Folgendes umfasst: eine Abdeckung (13), die mit der Seitenwand (12) des Gehäuses (1) verbunden ist, wobei die Abdeckung (13) eine Öffnung (131) aufweist, die auf den Lufteinlass (122) ausgerichtet ist.

7. Wärmeableitungsgebläse nach Anspruch 1, **dadurch gekennzeichnet, dass** die Basis (11) des Gehäuses (1) mehrere zusätzliche Lufteinlässe (122) aufweist.

## Revendications

1. Ventilateur de dissipation de chaleur comprenant :
un boîtier (1) comprenant une base (11) et une paroi latérale (12) couplée à la base (11), avec la paroi latérale (12) qui définit un compartiment (121), avec le boîtier (1) qui comprend en outre une entrée d'air (122) et une sortie d'air (123), avec l'entrée d'air (122) et la sortie d'air (123) qui sont en communication avec le compartiment (121) ;
un stator (2) couplé à la base (11) du boîtier (1) ;
une roue (3) couplée, en rotation, au stator (2) ; et
un élément de commande (4) comprenant un circuit d'entraînement (41) raccordé électriquement au stator (2) pour entraîner la rotation de la roue (3),
**caractérisé en ce que** :
le boîtier (1) comprend en outre un canal à poussières (124) faisant communiquer le compartiment (121) avec un extérieur, l'élément de commande (4) comprend en outre un circuit de commande de direction de rotation (42) électriquement raccordé au circuit d'entraînement (41),
dans lequel, lorsque le circuit de commande de direction de rotation (42) commande la rotation de la roue (3) dans une première direction, les courants d'air ambiant sont aspirés via l'entrée d'air (122) et passent à travers la sortie d'air (123) jusqu'à une source de chaleur pour dissiper la chaleur, et
dans lequel, lorsque le circuit de commande de direction de rotation (42) commande la rotation de la roue (3) dans une seconde direction opposée à la première direction, les courants d'air ambiant sont aspirés via l'entrée d'air (122) et sortent ensuite du boîtier (1) via le canal à poussières (124) pour éliminer la poussière accumulée à l'intérieur du boîtier (1).

2. Ventilateur de dissipation de chaleur selon la revendication 1, **caractérisé en ce que** la sortie d'air (123) comprend des premier et second bords d'extrémité (123a, 123b) opposés, avec le boîtier (1) qui définit un premier plan (P1) comprenant les premier et second bords d'extrémité (123a, 123b), avec la roue (3) qui comprend un moyeu (31) et une pluralité de pales (32) couplées à une périphérie externe du moyeu (31), avec la roue (3) qui définit un second plan (P2) comprenant un centre du moyeu (31), avec le second plan (P2) parallèle à et espacé du premier plan (P1), avec le compartiment (121) du boîtier (1) qui comprend une section de sortie d'air (121a) et une section d'accumulation de pression (121b) sur les côtés opposés du second plan (P2), avec la section de sortie d'air (121a) positionnée entre les premier et second plans (P1, P2) et avec le canal à poussières (124) positionnée dans la section d'accumulation de pression (121b).

3. Ventilateur de dissipation de chaleur selon la revendication 2, **caractérisé en ce que** le canal à poussières (124) s'étend dans un plan à un angle, perpendiculairement ou parallèlement par rapport au second plan (P2).

4. Ventilateur de dissipation de chaleur selon la revendication 1, **caractérisé en ce que** le ventilateur de dissipation de chaleur comprend en outre : un tuyau de guidage de poussière (15) fixé au canal à poussières (124).

5. Ventilateur de dissipation de chaleur selon la revendication 1, **caractérisé en ce que** le ventilateur de dissipation de chaleur comprend en outre : une pluralité d'ailettes (14) montées dans la sortie d'air (123) du boîtier (1).

6. Ventilateur de dissipation de chaleur selon la revendication 1, **caractérisé en ce que** le ventilateur de dissipation de chaleur comprend en outre : un couvercle (13) couplé à la paroi latérale (12) du boîtier (1), avec le couvercle (13) qui comprend une ouverture (131) alignée avec l'entrée d'air (122).

7. Ventilateur de dissipation de chaleur selon la revendication 1, **caractérisé en ce que** la base (11) du boîtier (1) comprend une pluralité d'entrées d'air auxiliaires (122).
